# EUROPEAN PATENT APPLICATION

(11) **EP 4 750 253 A1**
(43) Date of publication of application: **27.05.2026**
(21) Application number: 24220429.5
(22) Date of filing: 17.12.2024
(51) Int. Cl.: H10D 30/60, H10D 30/01, H10D 30/67

(54) **BODY CONTACTED TRANSISTORS**

(30) Priority: 20.11.2024 US 202418953745
(71) Applicant: GlobalFoundries U.S. Inc., Malta, NY 12020 (US)
(72) Inventor: CHOPPALLI, Vvss Satyasuresh, 560045 Bangalore (IN); DUTTA, Anupam, 560045 Bangalore (IN); TOH, Rui Tze, 738406 Singapore (SG)
(74) Representative: Lambacher, Michael

(57) **Abstract**

The present disclosure relates to semiconductor structures and, more particularly, to body contacted transistors and methods of manufacture. The structure includes: an active gate structure on a semiconductor substrate; at least one body contact extending through the active gate structure and connecting to a body region that contains a channel of the active gate which is under the active gate structure; and insulator material isolating the at least one body contact from the active gate structure.

## Description

### BACKGROUND

The present disclosure relates to semiconductor structures and, more particularly, to body contacted transistors and methods of manufacture.

A metal-oxide-semiconductor field-effect transistor (MOSFET) is a four-terminal device with gate structure, drain region and source region. Terminals are connected to the gate electrode of the gate structure, the drain region and the source region. Current conduction between the drain region and the source region is controlled by a voltage applied to the terminal of the gate structure. A MOSFET body contact is a connection that electrically links the body of a MOSFET to the semiconductor substrate. Body contact ties (BCTs) are used to prevent floating body effects, which can occur in SOI MOSFETs when there is no contact to the channel region.

### SUMMARY

In an aspect of the disclosure, a structure comprises: an active gate structure on a semiconductor substrate; at least one body contact extending through the active gate structure and connecting to a body region that contains a channel of the active gate which is under the active gate structure; and insulator material isolating the at least one body contact from the active gate structure.
Additional features of the structure are set forth in dependent claims 2 to 9.

In an aspect of the disclosure, a structure comprises: an active gate structure on a semiconductor material; at least one body contact extending through the active gate structure and connecting to the semiconductor material under the active gate structure; and at least a gate contact connecting to the active gate structure, remote from the at least one body contact.
Additional features of the structure are set forth in dependent claims 11 to 14.

In an aspect of the disclosure, a method comprises: forming an active gate structure on a semiconductor substrate; forming at least one body contact extending through the active gate structure and connecting to a body region that contains a channel of the active gate under the active gate structure; and forming insulator material isolating the at least one body contact from the active gate structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a top view of a structure and respective fabrication processes in accordance with aspects of the present disclosure.
FIG. 1B shows a cross-sectional view of the structure of FIG. 1A along lines "A"-"A".
FIGS. 2-4 show alternative structures and respective fabrication processes in accordance with aspects of the present disclosure.
FIGS. 5A-5E show fabrication steps for manufacturing the structure of FIGS. 1A and 1B.

### DETAILED DESCRIPTION

The present disclosure relates to semiconductor structures and, more particularly, to body contacted transistors and methods of manufacture. More specifically, the present disclosure relates to a body contacted metal oxide semiconductor field effect transistor (MOSFET). In embodiments, the body contacted MOSFET comprises a body contact reaching through an active gate structure to an underlying active region in a semiconductor substrate, e.g., body region under the active gate structure. In embodiments, the body contact(s) may be provided through a portion of a finger width of the active gate structure and/or distributed along the width of the active gate structure. Advantageously, the body contact provides effective body control irrespective of the width of the active gate structure, e.g., finger width, in addition to improving the linearity of RF amplifiers.

The structure of the present disclosure can be manufactured in a number of ways using a number of different tools. In general, though, the methodologies and tools are used to form structures with dimensions in the micrometer and nanometer scale. The methodologies, i.e., technologies, employed to manufacture the structure of the present disclosure have been adopted from integrated circuit (IC) technology. For example, the structures are built on wafers and are realized in films of material patterned by photolithographic processes on the top of a wafer. In particular, the fabrication of the structure uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

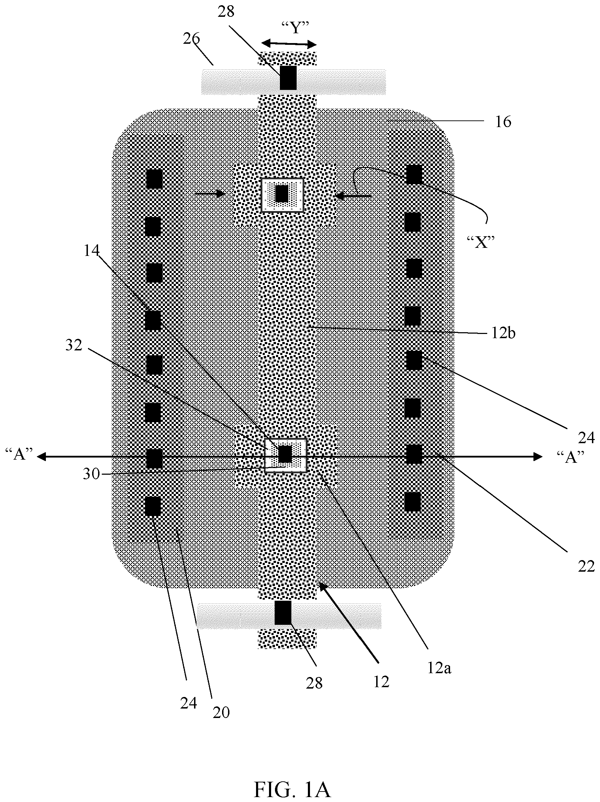

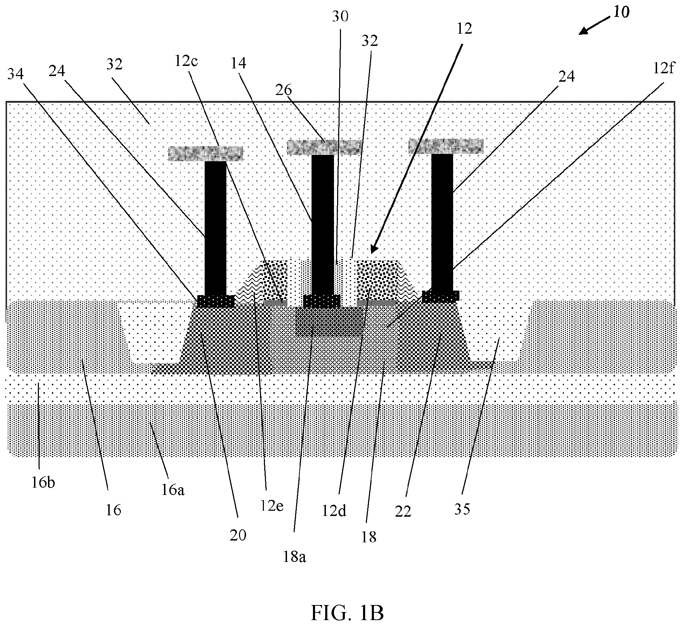

FIG. 1A shows a top view of a structure and respective fabrication processes in accordance with aspects of the present disclosure. FIG. 1B shows a cross-sectional view of the structure of FIG. 1A along line "A"-"A". More specifically and referring to FIGS. 1A and 1B, the structure 10 includes an active gate structure 12 with a body contact 14 extending through the active gate structure 12 to an underlying semiconductor substrate 16 and, more specifically, contacting to an active region 18 of the semiconductor substrate 16. In embodiments, the active gate structure 12 can be a finger structure with regions 12a, 12b comprising different dimensions "X", "Y", respectively, with "X">"Y". The body contact 14 extends through the region 12a comprising dimension "X", along the length of the active gate structure 12. In embodiments, a source region 20 and a drain region 22 are provided on opposing sides of the active gate structure 12.

Contacts 24 contact to the source region 20 and the drain region 22. Also, contacts 28 extend to and connect to the active gate structure 12 at ends thereof. In this way, the contacts 28 are gate contacts, directly connecting to a gate electrode as is known in the art It should be recognized that the contacts 14, 28 may be provided at other locations along the length of the active gate structure 14. In embodiments, the contacts 14, 24, 28 may connect to wiring structures 26 as shown more clearly in FIG. 1B. As should be understood by those of skill in the art, the contacts 14, 24, 28 may be via interconnect structures as described in more detail herein.

As shown further in FIGS. 1A and 1B, the body contact 14 is isolated from the active gate structure 12 by an insulator liner 30 and interlevel dielectric material 32. In embodiments, the insulator liner 30 may be nitride and the interlevel dielectric material 32 may be oxide. In this way, the body contacts 14 will not be shorted to the active gate structure 12. As described in more detail herein, it should be recognized by one of skill in the art that the insulator liner 30 may be optional.

As shown clearly in FIG. 1B, the active gate structure 12 is provided over an active region 18 in the semiconductor substrate 16. The contact 14 may extend to and contact the active region 18. In optional embodiments, a p+ diffusion region 18a may be provided in the active region 18, between the source region 20 and the drain region 22. In this optional embodiment, the contact 12 will extend through the active gate structure 14 and contact the p+ diffusion region 18a. The active region 18 may be the body region (e.g., p-well) in the semiconductor substrate 16, bounded or isolated from other structures by shallow trench isolation structures 35. The active region 18, e.g., body region, can be doped with a p-type dopant, e.g., boron, using an ion implant process as further described herein.

The semiconductor substrate 16 may be composed of any suitable material including, but not limited to, Si, SiGe, SiGeC, SiC, GaAs, InAs, InP, and other III/V or II/VI compound semiconductors. In embodiments, the semiconductor substrate 16 may be a p-type semiconductor substrate with a suitable single crystallographic orientation (e.g., a (100), (110), (111), or (001) crystallographic orientation).

The semiconductor substrate 16 may be semiconductor-on-insulator (SOI) technology. In the SOI technology, a handle substrate 16a and the semiconductor substrate 16 may include the same semiconductor material as noted herein. As is known in the art, the handle substrate 16a provides mechanical support to a buried insulator layer 16b and the top semiconductor layer, e.g., semiconductor substrate 16. The buried insulator layer 16b may include a dielectric material such as silicon dioxide, silicon nitride, silicon oxynitride, boron nitride or a combination thereof. In one preferred embodiment, the buried insulator layer 16b may be a buried oxide layer formed by a deposition process, such as chemical vapor deposition (CVD), plasma enhanced chemical vapor deposition CVD (PECVD) or physical vapor deposition (PVD), or a thermal growth process as is known in the art such that no further explanation is required herein for a complete understanding of the present disclosure.

The active region 18 and p+ diffusion region 18a may be formed by an ion implantation process. For example, patterned implantation masks may be used to define selected areas exposed for the implantation, e.g., active region 18 and p+ diffusion region 18a. The implantation masks may include a layer of a light-sensitive material, such as an organic photoresist, applied by a spin coating process, pre-baked, exposed to light projected through a photomask, baked after exposure, and developed with a chemical developer. The implantation masks have a thickness and stopping power sufficient to block the masked area against receiving a dose of the implanted ions. The active region 18 and p+ diffusion region 18a may be separately doped with p-type dopants, e.g., boron, among other suitable examples.

The shallow trench isolation structures 35 can be formed by conventional lithography, etching and deposition methods known to those of skill in the art. For example, a resist formed over the semiconductor substrate 16 is exposed to energy (light) and developed utilizing a conventional resist developer to form a pattern (opening(s)). An etching process with a selective chemistry, e.g., reactive ion etching (RIE), will be used to transfer the pattern to form one or more trenches in the semiconductor substrate 16 through the openings of the resist. Following the resist removal by a conventional oxygen ashing process or other known stripants, insulator material, e.g., oxide, can be deposited by any conventional deposition processes, e.g., chemical vapor deposition (CVD) processes. Any residual material on the surface of the semiconductor substrate 16 can be removed by conventional chemical mechanical polishing (CMP) processes.

As further shown in FIG. 1B, the active gate structure 12 includes a gate dielectric material 12c and a gate electrode 12d. In embodiments, the gate dielectric material 12b may be a high-k or low-k dielectric material as is known in the art. For example, a high-k dielectric material may be a hafnium based material and a low-k dielectric material may be oxide. The gate electrode material 12b may be a polysilicon material. Sidewall spacers 12e are formed on the sidewalls on the gate structure 12, e.g., gate dielectric material 12c and gate electrode 12d. The sidewall spacers 12e may be oxide and/or nitride material or combinations thereof as is known in the art. A channel region 12f is provided under the gate structure 12, between the source region 20 and the drain region 22.

Although not critical to the understanding of the present disclosure, the active gate structure 12 can be fabricated using conventional CMOS processes. In the standard CMOS processing, the gate dielectric material 12c and gate electrode material 12d, e.g., polysilicon material, are formed, e.g., deposited, on the semiconductor substrate 16, followed by a patterning process. An insulator material such as nitride or oxide can be deposited on the patterned materials, followed by an anisotropic etching process to form the sidewall structures 12e. The gate dielectric material 12c may be deposited by a conventional CVD process or, alternatively, an atomic layer deposition (ALD) or plasma-enhanced CVD (PECVD) as other examples. The material of the sidewall structures 12e and the gate electrode material 12d may be deposited by a CVD process, with the sidewall structures 12e being patterned by an anisotropic etching process as is known in the art.

The source region 20 and the drain region 22 may be formed by ion implantation processes as described herein such that no further explanation is required for a complete understanding of the present disclosure. Alternatively, the source region 20 and the drain region 22 may be formed by an epitaxial growth process with an in-situ doping process to form a raised source region and a raised drain region as is known in the art. In embodiments, epitaxy regions (source/drain regions) may be any appropriate semiconductor material, e.g., Si or III-V compound semiconductor materials, combinations thereof, or multi-layers thereof. The in-situ doping process may include any appropriate dopant type, e.g., n-type impurity. An annealing process may be performed to drive in the dopant into the semiconductor substrate 16, e.g., into the active region 18.

Silicide contacts 34 may be provided in contact with the source region 20, drain region 20, gate electrode 12c and active region 18. As should be understood by those of skill in the art, the silicide process begins with deposition of a thin transition metal layer, e.g., nickel, cobalt or titanium, over fully formed and patterned semiconductor material (e.g., source region 20, drain region 20, gate electrode 12c and active region 18). After deposition of the material, the structure is heated allowing the transition metal to react with exposed silicon (or other semiconductor material as described herein) in the active regions of the semiconductor device (e.g., source region 14, drain region 16, gate electrode 12b, and the p+ diffusion regions 18a) forming a low-resistance transition metal silicide. Following the reaction, any remaining transition metal is removed by chemical etching, leaving silicide contacts 34.

As further shown in FIGS. 1A and 1B, via interconnect structures (e.g., contacts) 14, 24, 28 may be formed to contact the silicide contacts 34. The via interconnect structures 14, 24, 28 may be any conductive material used in fabricating of contacts, e.g., tungsten, TiN, TaN, etc.

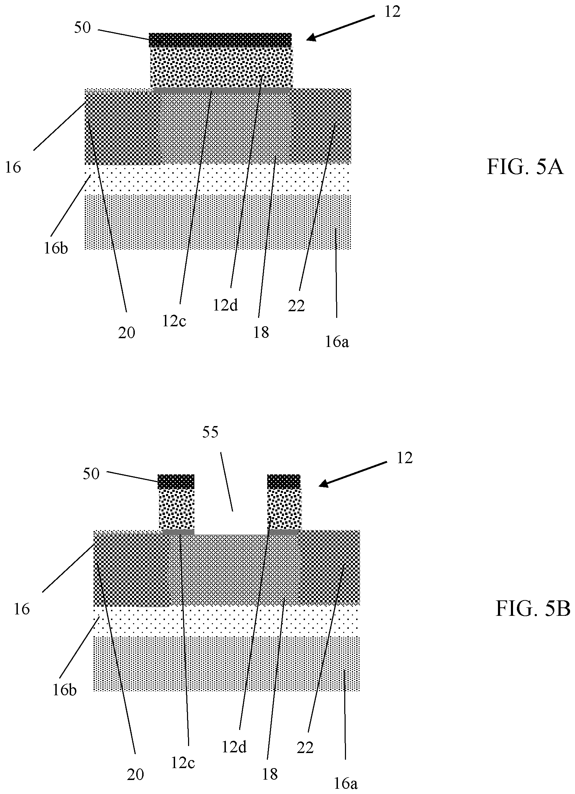

The via interconnect structures 14, 24, 28 may be formed by conventional lithography, etching and deposition methods known to those of skill in the art. An explanation of the formation of the via interconnect structure 14 is provided in FIGS. 5A-5E. As to the via interconnect structures 24, 28, a resist formed over an insulator material (interlevel dielectric material) 32 is exposed to energy (light) and developed utilizing a conventional resist developer to form a pattern (opening). An etching process with a selective chemistry, e.g., reactive ion etching (RIE), will be used to transfer the pattern from the photoresist layer to the insulator material 32 (e.g., interlevel dielectric material) to form one or more trenches in the insulator material 32. Following the resist removal by a conventional oxygen ashing process or other known stripants, conductive material can be deposited by any conventional deposition processes, e.g., chemical vapor deposition (CVD) processes. Any residual material on the surface of the insulator material 32 can be removed by conventional chemical mechanical polishing (CMP) processes.

Wiring structures 26 may be provided in contact to the via interconnect structures 22, 24, 36 using conventional lithography, etching and deposition methods known to those of skill in the art and as already described herein. The wiring structures 26 may be composed of any conventional conductive material used for wiring structures, e.g., copper, aluminum, etc.

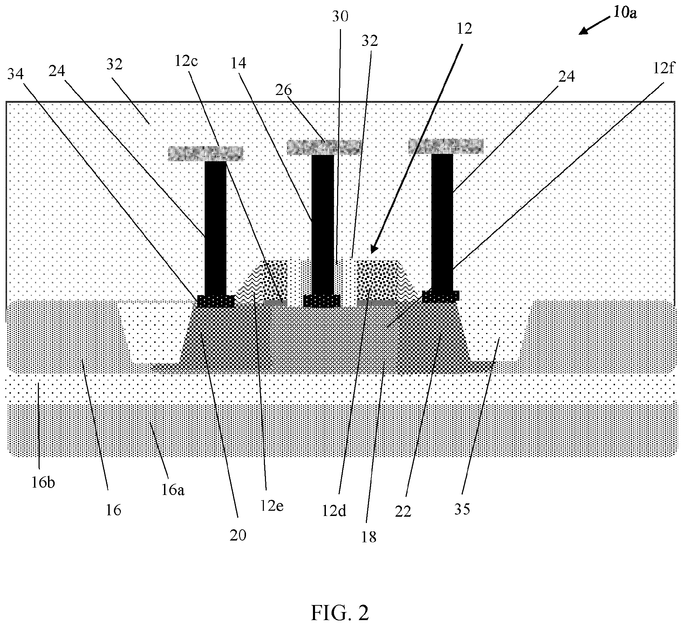

FIGS. 2-4 show alternative structures and respective fabrication processes in accordance with aspects of the present disclosure. In FIG. 2, the structure 10a does not include the p+ diffusion region; instead, the contact 14 connects directly to the active region 18. In this embodiment, a Schottky contact is created without the p+ region under the contact 14, which is useful feature for RF switch applications. The remaining features of FIG. 2 are similar to the structure 10 shown and described with respect to FIGS. 1A and 1B.

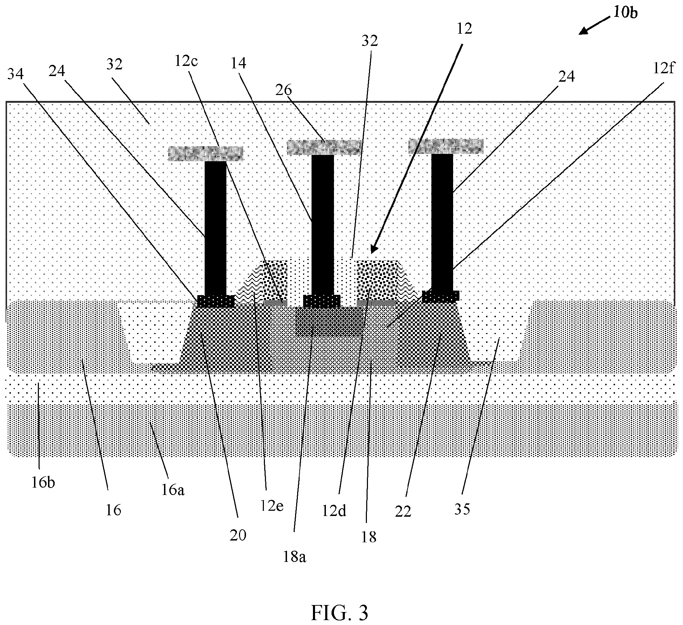

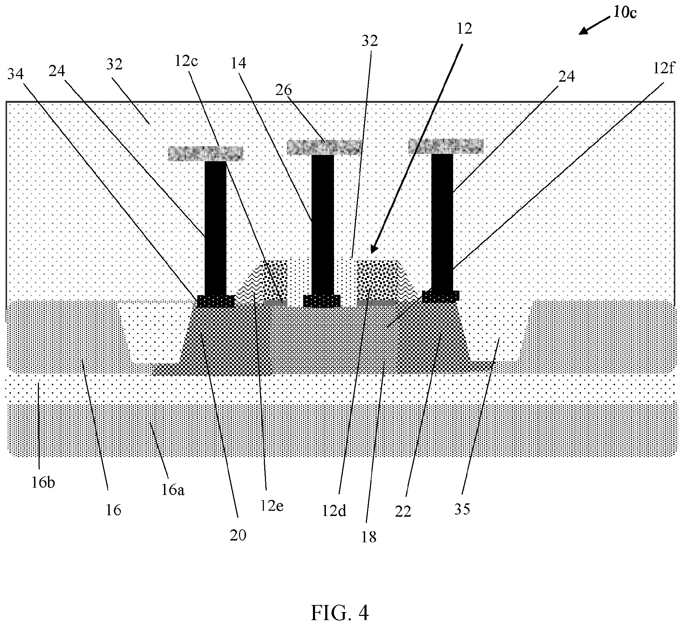

In FIG. 3, the structure 10b does not include an insulator liner around the contact 14; instead, only an interlevel dielectric material 32 will be used to isolate the contact 14 from the active gate structure 12. In FIG. 4, the structure 10c does not include an insulator liner around the contact 14 or the p+ diffusion region; instead, only an interlevel dielectric material 32 will be used to isolate the contact 14 from the active gate structure 12 and the contact 14 connects directly to the active region 18. The remaining features of FIGS. 3 and 4 are similar to the structure 10 shown and described with respect to FIGS. 1A and 1B.

FIGS. 5A-5E show fabrication steps for manufacturing the structure of FIGS. 1A and 1B. For example, in FIG. 5A, the source region 20, the drain region 22 and the active region 18, e.g., p-body region, are formed by ion implantation processes as already described herein. The gate dielectric material 12c, the gate electrode material 12d, e.g., polysilicon material, and a hardmask 50 (e.g., nitride) are formed on the semiconductor substrate 16, followed by a conventional lithography and etching process. The gate dielectric material 12c may be deposited by a conventional CVD process or, alternatively, an atomic layer deposition (ALD) or plasma-enhanced CVD (PECVD) as other examples. The gate electrode material 12d and the hardmask 50 may be deposited using CVD, for example. The patterning of the gate dielectric material 12c and the gate electrode material 12d will form the active gate structure 12.

In FIG. 5B, an opening 55 is formed through the gate dielectric material 12c, the gate electrode material 12d, and the hardmask 50 to expose the underlying active region 18. The opening 55 may be formed by conventional lithography and etching (RIE) processes as already described herein.

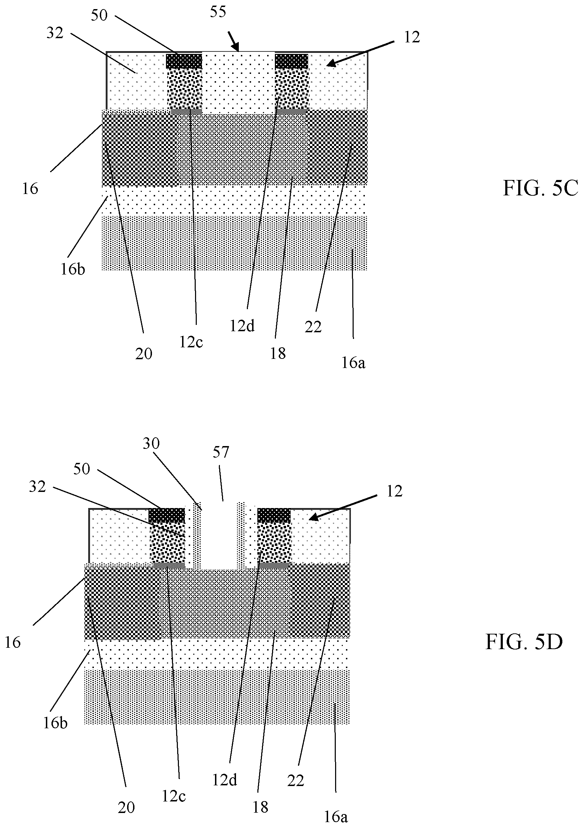

In FIG. 5C, an insulator material 32 is deposited within the opening and over the patterned materials 12c, 12d, 50. The insulator material 32 may be an interlevel dielectric material, e.g., oxide, deposited using a conventional CVD process. The insulator material 32 should completely fill the opening 55. The insulator material 32 may undergo a planarization process, e.g., chemical mechanical polishing, to planarize the surface of the insulator material 32.

In FIG. 5D, an opening 57 is formed within the insulator material 32 aligned within and between the patterned materials 12c, 12d, 50. The opening 57 will expose the underlying semiconductor material 16, e.g., body region 18a, while also leaving insulator material 32 on the sidewall on the patterned materials 12c, 12d, 50, e.g., active gate structure 12. A liner material 30, e.g., nitride, may be deposited within the opening 57 and patterned using an anisotropic etching to form a sidewall on the insulator material 32.

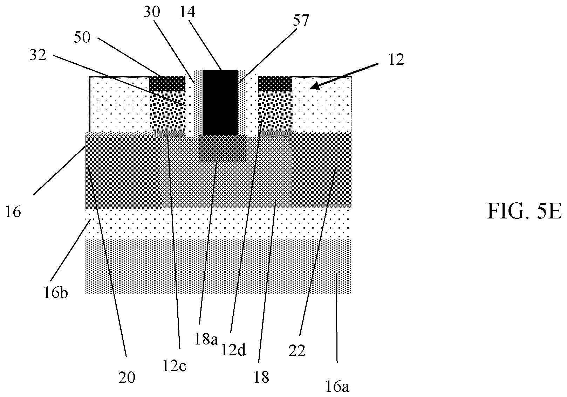

In FIG. 5E, the optional p+ diffusion region 18a may be formed through the opening 57 using ion implantation processes as described herein. The contact 14 may be formed in the opening 57 using conventional deposition methods, e.g., CVD. In embodiments, the contact 14 is surrounded by the active gate structure 14 and contacts to the underlying body region 18a. Also, the liner material 20 and the insulator material 30 will electrically insulate, e.g., isolate, the contact 14 from the active gate structure 12.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. For example, the present disclosure is applicable to NMOSFETs and PMOSFETs as well with the opposite doping types as described herein. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
an active gate structure on a semiconductor substrate;
at least one body contact extending through the active gate structure and connecting to a body region that contains a channel of the active gate under the active gate structure; and
insulator material isolating the at least one body contact from the active gate structure.

2. The structure of claim 1, wherein the at least one body contact comprises a conductive material which contacts a body contact region in the semiconductor substrate under the active gate structure.

3. The structure of claim 2, wherein the body contact region comprises a p-body region, or wherein the body contact region comprises a p+ diffusion region within a channel region under the active gate structure and the at least one body contact contacts the p+ diffusion region.

4. The structure of one of claims 1 to 3, wherein the at least one body contact comprises multiple body contacts extending along a length of the active gate structure.

5. The structure of one of claims 1 to 4, wherein the insulator material comprises interlevel dielectric material, or wherein the insulator material comprises interlevel dielectric material and an insulator liner material between the at least one body contact and the interlevel dielectric material.

6. The structure of one of claims 1 to 5, wherein the active gate structure comprises a MOSFET, and/or wherein the semiconductor substrate comprises semiconductor on insulator material.

7. The structure of one of claims 1 to 6, further comprising a gate contact connecting to the active gate structure, remote from the at least one body contact.

8. The structure of one of claims 1 to 7, wherein the active gate structure comprises a length with a first dimension and a second dimension greater than the first dimension, and the at least one body contact extends through the active gate structure at the second dimension.

9. The structure of one of claims 1 to 8, wherein the active gate structure comprises a polysilicon material.

10. A structure comprising:
an active gate structure on a semiconductor material;
at least one body contact extending through the active gate structure and connecting to the semiconductor material under the active gate structure; and
at least a gate contact connecting to the active gate structure, remote from the at least one body contact.

11. The structure of claim 10, wherein the at least one body contact comprises multiple body contacts extending through the active gate structure along a length thereof.

12. The structure of claim 10 or claim 11, further comprising insulator material between the at least one body contact and the active gate structure, and, optionally, wherein the insulator material is a liner surrounding the at least one body contact and an interlevel dielectric material between the liner and the active gate structure.

13. The structure of one of claims 10 to 12, wherein the active gate structure comprises a length with a first-cross sectional dimension and a second-cross sectional dimension, the first-cross sectional dimension is larger than the second-cross sectional dimension, and the at least one body contact extends through the first cross-sectional dimensions.

14. The structure of one of claims 10 to 13, wherein the at least one contact contacts a p+ diffusion region under the active gate structure, and/or wherein the semiconductor substate comprises semiconductor on insulator technology.

15. A method comprising:
forming an active gate structure on a semiconductor substrate;
forming at least one body contact extending through the active gate structure and connecting to a body region that contains a channel of the active gate which is under the active gate structure; and
forming insulator material isolating the at least one body contact from the active gate structure.
